# EUROPEAN PATENT APPLICATION

(11) **EP 3 273 497 A1**
(43) Date of publication of application: **24.01.2018**
(21) Application number: 16768669.0
(22) Date of filing: 18.03.2016
(51) Int. Cl.: H01L 51/44, H01L 51/46

(54) **FLEXIBLE SOLAR CELL**

(30) Priority: 20.03.2015 JP 2015058421
(71) Applicant: Sekisui Chemical Co., Ltd., Osaka-shi, Osaka 530-0047 (JP)
(72) Inventor: HAYAKAWA, Akinobu, Mishima-gun Osaka 618-0021 (JP); ASANO, Motohiko, Mishima-gun Osaka 618-0021 (JP); OHARA, Shunji, Mishima-gun Osaka 618-0021 (JP); YUKAWA, Mayumi, Mishima-gun Osaka 618-0021 (JP); UNO, Tomohito, Mishima-gun Osaka 618-0021 (JP); MURAKAMI, Junnosuke, Gamagori-shi Aichi 443-0036 (JP)
(74) Representative: Hart-Davis, Jason
(86) International application number: PCT/JP2016/058663
(87) International publication number: WO 2016/152766

(57) **Abstract**

The present invention aims to provide a flexible solar cell including a photoelectric conversion layer that contains an organic-inorganic perovskite compound and being excellent in light resistance and photoelectric conversion efficiency. The present invention relates to a flexible solar cell having a structure including: a metal foil; an electron transport layer; a photoelectric conversion layer; a hole transport layer; and a transparent electrode stacked in the stated order, the photoelectric conversion layer containing an organic-inorganic perovskite compound represented by the formula: R-M-X₃ where R represents an organic molecule, M represents a metal atom, and X represents a halogen atom or a chalcogen atom.

## Description

### TECHNICAL FIELD

The present invention relates to a flexible solar cell including a photoelectric conversion layer that contains an organic-inorganic perovskite compound and being excellent in light resistance and photoelectric conversion efficiency.

### BACKGROUND ART

Known solar cells include rigid solar cells having a glass substrate and flexible solar cells having a substrate of a heat-resistant polymeric material such as a polyimide material or a polyester material. Flexible solar cells have received attention recently for their advantages including high impact resistance and easy transportation and construction owing to their thin profiles and lightweight properties.

Such a flexible solar cell is produced by stacking thin-film components such as a photoelectric conversion layer made of a silicon semiconductor or compound semiconductor generating a current under irradiation with light, on a flexible substrate made of a heat-resistant polymeric material such as a polyimide material or a polyester material. If necessary, top and bottom faces of the solar cell element are each sealed with a solar cell sealing sheet (see Patent Literature 1, for example).

### CITATION LIST

### - Patent Literature

Patent Literature 1: WO 2012/046564

### SUMMARY OF INVENTION

### - Technical Problem

The present inventors have studied about, as a novel flexible solar cell, a flexible solar cell including a photoelectric conversion layer that contains an organic-inorganic perovskite compound represented by the formula: R-M-X₃. The use of a specific organic-inorganic perovskite compound in a photoelectric conversion layer enables production of a solar cell with high photoelectric conversion efficiency.

However, a flexible solar cell including a photoelectric conversion layer that contains an organic-inorganic perovskite compound is disadvantageous in terms of the light resistance for its reduction in the photoelectric conversion efficiency by irradiation with light. The present inventors have found out that annealing in which a formed photoelectric conversion layer is heated to a temperature of 80°C or higher can increase the degree of crystallinity of the organic-inorganic perovskite compound, thereby overcoming the disadvantage in terms of the light resistance. However, in production of a flexible solar cell including a photoelectric conversion layer that contains an organic-inorganic perovskite compound by a conventional method in which a photoelectric conversion layer and the like are stacked on a flexible substrate made of a heat-resistant polymeric material such as a polyimide material or a polyester material, a strain may be generated during the annealing due to a difference in the linear expansion coefficient between the flexible substrate and the photoelectric conversion layer and the like. In such a case, high photoelectric conversion efficiency is hard to achieve. Moreover, in a case where a metal oxide is used for an electron transport layer and annealing at high temperature is not performed, it is difficult to achieve high conversion efficiency.

The present invention aims to provide, in consideration of the state of the art, a flexible solar cell including a photoelectric conversion layer that contains an organic-inorganic perovskite compound and being excellent in light resistance and photoelectric conversion efficiency.

### - Solution to problem

The present invention relates to a flexible solar cell having a structure including: a metal foil; an electron transport layer; a photoelectric conversion layer; a hole transport layer; and a transparent electrode stacked in the stated order, the photoelectric conversion layer containing an organic-inorganic perovskite compound represented by the formula: R-M-X₃ where R represents an organic molecule, M represents a metal atom, and X represents a halogen atom or a chalcogen atom.

The present invention is specifically described in the following.

The flexible solar cell of the present invention has a structure in which a metal foil, an electron transport layer, a photoelectric conversion layer, a hole transport layer, and a transparent electrode are stacked in the stated order.

The metal foil serves as a substrate of the flexible solar cell. The metal foil may serve as both one electrode and a substrate of the flexible solar cell. The use of a metal foil as a substrate can minimize generation of a strain even after annealing at a temperature of 80°C or higher for the purpose of imparting light resistance in a step of forming a photoelectric conversion layer described later. As a result, a flexible solar cell with high photoelectric conversion efficiency can be obtained. Preferably, the metal foil is substantially flat.

The metal foil may be constituted by any metal, and one having excellent durability and conductivity to be usable as an electrode is preferred. Examples thereof include metals such as aluminum, titanium, copper, and gold, and alloys such as stainless steel (SUS). These materials may be used alone, or in combination of two or more thereof.

In particular, the metal foil is preferably constituted by a metal containing stainless steel (SUS). The use of stainless steel (SUS) as a metal constituting the metal foil makes the metal foil tough to improve the durability against bending, thereby suppressing variation in the photoelectric conversion efficiency due to bending deformation. The metal foil is also preferably constituted by a metal containing aluminum. The use of aluminum as a metal constituting the metal foil reduces a difference in the linear expansion coefficient between the metal foil and the photoelectric conversion layer that contains an organic-inorganic perovskite compound, thereby further suppressing generation of a strain during the annealing.

The metal foil may have any thickness. The lower limit of the thickness is preferably 5 µm, while the upper limit thereof is preferably 500 µm. The metal foil having a thickness of 5 µm or more imparts sufficient mechanical strength to the flexible solar cell to be obtained, leading to better handleability. The metal foil having a thickness of 500 µm or less can be bent, leading to better flexibility. The lower limit of the thickness of the metal foil is more preferably 10 µm, while the upper limit thereof is more preferably 100 µm.

In a case where the metal foil is used as a substrate of a flexible solar cell, there may be a mode in which the metal foil itself simultaneously serves as both an electrode and a substrate or a mode in which an electrode is formed on a surface of the metal foil on the photoelectric conversion layer side with an insulating layer interposed therebetween.

The insulating layer is not particularly limited, and is preferably an insulating layer including an insulating resin layer or a metal oxide layer. More specifically, the insulating layer is preferably made of an insulating resin (e.g., polyimide resin, silicone resin) or a metal oxide (e.g., zirconia, silica, hafnia).

The lower limit of the thickness of the insulating layer is preferably 0.1 µm, while the upper limit thereof is preferably 10 µm. With the thickness of the insulating layer within this range, the metal foil and the electrode can be surely insulated from each other.

The electrode formed on a surface of the metal foil on the photoelectric conversion layer side with an insulating layer interposed therebetween is not particularly limited, and may be one commonly used in a solar cell.

The electron transport layer is preferably formed on the metal foil or on the electrode formed on a surface of the metal foil on the photoelectric conversion layer side with an insulating layer interposed therebetween. Examples of the material of the electron transport layer include, but are not particularly limited to, N-type conductive polymers, N-type low-molecular organic semiconductors, N-type metal oxides, N-type metal sulfides, alkali metal halides, alkali metals, and surfactants. Specific examples thereof include cyano group-containing polyphenylene vinylene, boron-containing polymers, bathocuproine, bathophenanthroline, hydroxy quinolinato aluminum, oxadiazole compounds, benzimidazole compounds, naphthalene tetracarboxylic acid compounds, perylene derivatives, phosphine oxide compounds, phosphine sulfide compounds, fluoro group-containing phthalocyanine, titanium oxide, zinc oxide, indium oxide, tin oxide, gallium oxide, tin sulfide, indium sulfide, and zinc sulfide.

The lower limit of the thickness of the electron transport layer is preferably 1 nm, while the upper limit thereof is preferably 2,000 nm. The electron transport layer with a thickness of 1 nm or larger can sufficiently block holes. The electron transport layer with a thickness of 2,000 nm or smaller is less likely to be a resistance to the electron transport, enhancing the photoelectric conversion efficiency. The lower limit of the thickness of the electron transport layer is more preferably 3 nm, while the upper limit thereof is more preferably 1,000 nm. The lower limit of the thickness is still more preferably 5 nm, while the upper limit thereof is still more preferably 500 nm.

The electron transport layer is formed, for example, by a method including an electron transport layer forming step in which an electron transport layer is formed on the metal foil.

An electron transport layer may be formed on the metal foil by any method. For example, in the case of forming an electron transport layer made of titanium oxide, a coating liquid containing titanium is applied to the metal foil and then fired to form a thin-film electron transport layer, and on the thin-film electron transport layer is applied a titanium oxide paste containing an organic binder and titanium oxide particles, and the applied paste was fired to form a porous electron transport layer. In another exemplary method, the metal foil is sputtered with titanium, and the surface thereof is oxidized to obtain titanium oxide serving as an electron transport layer.

The photoelectric conversion layer contains an organic-inorganic perovskite compound represented by the formula: R-M-X₃ (R represents an organic molecule, M represents a metal atom, and X represents a halogen atom or a chalcogen atom).

The use of the organic-inorganic perovskite compound contributes to excellent photoelectric conversion efficiency of the flexible solar cell of the present invention.

Hereinbelow, a part containing the organic-inorganic perovskite compound represented by the formula R-M-X₃ is also referred to as an organic-inorganic perovskite compound part.

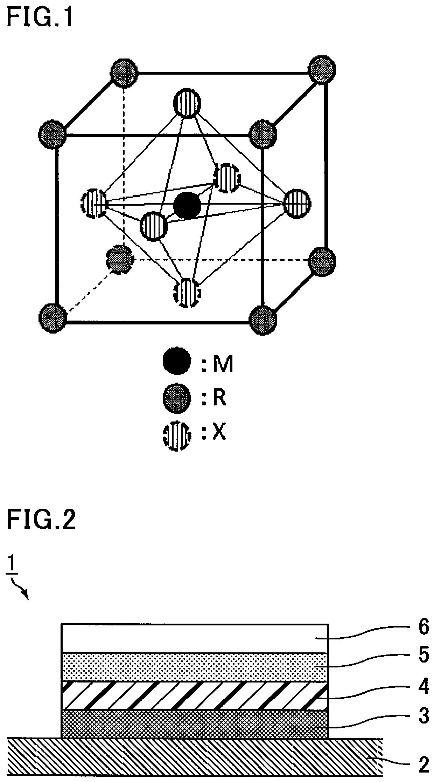

The organic-inorganic perovskite compound represented by the formula: R-M-X₃ preferably has a cubic structure where the metal atom M is placed at the body center, the organic molecule R is placed at each vertex, and the halogen atom or chalcogen atom X is placed at each face center. Fig. 1 illustrates such a cubic structure where the metal atom M is placed at the body center, the organic molecule R is placed at each vertex, and the halogen atom or chalcogen atom X is placed at each face center. Although details are not clear, it is presumed that the orientation of an octahedron in the crystal lattice can be easily changed owing to the structure; thus the mobility of electrons is enhanced, achieving high photoelectric conversion efficiency.

In the formula: R-M-X₃ of the organic-inorganic perovskite compound, R is an organic molecule and is preferably a molecule represented by CₗNₘXₙ (1, m, and n each represent a positive integer). Specific examples of R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethyl methylamine, methyl propylamine, butyl methylamine, methyl pentylamine, hexyl methylamine, ethyl propylamine, ethyl butylamine, imidazole, azole, pyrrole, aziridine, azirine, azetidine, azete, imidazoline, carbazole and their ions (e.g., methylammonium (CH₃NH₃)), and phenethylammonium. Among them, preferred are methylamine, ethylamine, propylamine, butylamine, pentylamine, hexylamine and their ions, and phenethylammonium. More preferred are methylamine, ethylamine, propylamine and their ions.

In the formula, M is a metal atom. Examples thereof include lead, tin, zinc, titanium, antimony, bismuth, nickel, iron, cobalt, silver, copper, gallium, germanium, magnesium, calcium, indium, aluminum, manganese, chromium, molybdenum, and europium. These elements may be used alone or in combination of two or more thereof. X is a halogen atom or a chalcogen atom. Examples thereof include chlorine, bromine, iodine, sulfur, and selenium. These elements may be used alone or in combination of two or more thereof. Among them, a halogen atom is preferred because the organic-inorganic perovskite compound containing halogen in the structure is soluble in an organic solvent and is usable in an inexpensive printing method or the like. In addition, iodine is more preferred because the organic-inorganic perovskite compound has a narrow energy band gap.

X is a halogen atom or a chalcogen atom. The organic-inorganic perovskite compound containing halogen in the structure is soluble in an organic solvent and is usable in an inexpensive printing method or the like.

The photoelectric conversion layer may further contain an organic semiconductor or an inorganic semiconductor, in addition to the organic-inorganic perovskite compound, without impairing the effects of the present invention. In this context, the organic semiconductor or the inorganic semiconductor may play a role as an electron transport layer or a hole transport layer.

Examples of the organic semiconductor include compounds having a thiophene skeleton, such as poly(3-alkylthiophene). Examples thereof also include conductive polymers having a poly-p-phenylenevinylene skeleton, a polyvinylcarbazole skeleton, a polyaniline skeleton, a polyacetylene skeleton or the like. Examples thereof further include: compounds having a phthalocyanine skeleton, a naphthalocyanine skeleton, a pentacene skeleton, a porphyrin skeleton such as a benzoporphyrin skeleton, a spirobifluorene skeleton or the like; and carbon-containing materials such as carbon nanotube, graphene, and fullerene, which may be surface-modified.

Examples of the inorganic semiconductor include titanium oxide, zinc oxide, indium oxide, tin oxide, gallium oxide, tin sulfide, indium sulfide, zinc sulfide, CuSCN, Cu₂O, CuI, MoO₃, V₂O₅, WO₃, MoS₂, MoSe₂, and Cu₂S.

The photoelectric conversion layer containing the organic semiconductor or the inorganic semiconductor may be a laminate where a thin-film organic semiconductor part or an inorganic semiconductor part and a thin-film organic-inorganic perovskite compound part are stacked, or may be a composite film where an organic semiconductor part or an inorganic semiconductor part and an organic-inorganic perovskite compound part are combined. The laminate is preferred from the viewpoint that the production process is simple. The composite film is preferred from the viewpoint that the charge separation efficiency of the organic semiconductor or the inorganic semiconductor can be improved.

The lower limit of the thickness of the thin-film organic-inorganic perovskite compound part is preferably 5 nm, while the upper limit thereof is preferably 5,000 nm. The thin-film organic-inorganic perovskite compound part with a thickness of 5 nm or more can sufficiently absorb light, enhancing the photoelectric conversion efficiency. The thin-film organic-inorganic perovskite compound part with a thickness of 5,000 nm or less can suppress formation of a region where charge separation cannot be achieved, leading to higher photoelectric conversion efficiency. The lower limit of the thickness is more preferably 10 nm, while the upper limit thereof is more preferably 1,000 nm. The lower limit is still more preferably 20 nm, while the upper limit is still more preferably 500 nm.

When the photoelectric conversion layer is a composite film where an organic semiconductor part or an inorganic semiconductor part and an organic-inorganic perovskite compound part are combined, the lower limit of the thickness of the composite film is preferably 30 nm, while the upper limit thereof is preferably 3,000 nm. The composite film with a thickness of 30 nm or more can sufficiently absorb light, enhancing the photoelectric conversion efficiency. The composite film with a thickness of 3,000 nm or less allows the charge to easily arrive at the electrode, enhancing the photoelectric conversion efficiency. The lower limit of the thickness is more preferably 40 nm, while the upper limit thereof is more preferably 2,000 nm. The lower limit is still more preferably 50 nm, while the upper limit is still more preferably 1,000 nm.

The photoelectric conversion layer is preferably formed by a method including a photoelectric conversion layer forming step in which a photoelectric conversion layer containing an organic-inorganic perovskite compound is formed on the electron transport layer and then annealed at a temperature of 80°C or higher.

The photoelectric conversion layer may be formed on the electron transport layer by any method, and examples thereof include vacuum evaporation, sputtering, chemical vapor deposition (CVD), electrochemical deposition, and printing methods. Among them, employment of a printing method allows simple formation of a large-area flexible solar cell that can exhibit high photoelectric conversion efficiency. Examples of the printing method include a spin coating method and a casting method. Examples of the method using the printing method include a roll-to-roll method.

The photoelectric conversion layer is specifically formed, for example, by applying a solution for forming an organic-inorganic perovskite compound (i.e., a precursor solution of an organic-inorganic perovskite compound) on the electron transport layer to form the thin-film organic-inorganic perovskite compound part and then forming the thin-film organic semiconductor part on the thin-film organic-inorganic perovskite compound part.

The annealing imparts light resistance to the photoelectric conversion layer containing an organic-inorganic perovskite compound. The annealing treatment increases the degree of crystallinity of the organic-inorganic perovskite compound, presumably leading to excellent light resistance. An increase in the degree of crystallinity increases the mobility of electrons to enhance the photoelectric conversion efficiency.

In a conventional production method of a flexible solar cell, heat during the annealing may cause a strain due to a difference in the linear expansion coefficient between the substrate and the photoelectric conversion layer and the like. In the flexible solar cell of the present invention, however, such a strain is hardly caused because a metal foil is used as a substrate.

The degree of crystallinity can be determined by separating a crystalline substance-derived scattering peak from an amorphous portion-derived halo, which are detected by X-ray scattering intensity distribution measurement, by fitting, determining their respective intensity integrals, and calculating the ratio of the crystalline portion to the whole.

The lower limit of the degree of crystallinity of the organic-inorganic perovskite compound is preferably 30%. The organic-inorganic perovskite compound with a degree of crystallinity of 30% or more enhances the mobility of electrons, improving the photoelectric conversion efficiency. The lower limit of the degree of crystallinity is more preferably 50%, still more preferably 70%.

The annealing temperature is preferably 80°C or higher. The annealing treatment at a temperature of 80°C or higher can increase the degree of crystallinity of the organic-inorganic perovskite compound, leading to production of a flexible solar cell having excellent light resistance and high photoelectric conversion efficiency. The annealing temperature is more preferably 100°C or higher, still more preferably 120°C or higher.

The upper limit of the annealing temperature is not particularly limited, and is substantially 200°C because a temperature higher than 200°C does not give any further effect of increasing the degree of crystallinity and rather gives an adverse effect on other members.

The heating time for the annealing is not particularly limited, and is preferably three minutes or longer and two hours or shorter. The heating time of three minutes or longer can sufficiently increase the degree of crystallinity of the organic-inorganic perovskite compound. The heating time of two hours or shorter allows heating treatment without thermal degradation of the organic-inorganic perovskite compound.

The heating operation is preferably performed under vacuum or under inert gas. The dew-point temperature is preferably 10°C or lower, more preferably 7.5°C or lower, still more preferably 5°C or lower.

Examples of the material of the hole transport layer include, but are not particularly limited to, P-type conductive polymers, P-type low-molecular organic semiconductors, P-type metal oxides, P-type metal sulfides, and surfactants. Specific examples thereof include polystyrene sulfonate-doped polyethylene dioxythiophene, carboxy group-containing polythiophene, phthalocyanine, porphyrin, molybdenum oxide, vanadium oxide, tungsten oxide, nickel oxide, copper oxide, tin oxide, molybdenum sulfide, tungsten sulfide, copper sulfide, tin sulfide, fluoro group-containing phosphonic acid, and carbonyl group-containing phosphonic acid.

The hole transport layer is preferably a hole transport layer containing an amorphous organic semiconductor. The use of an amorphous organic semiconductor releases stress upon formation of a transparent electrode, leading to high conversion efficiency.

The amorphous organic semiconductor may be, for example, poly(4-butylphenyl-diphenyl-amine).

The lower limit of the thickness of the hole transport layer is preferably 1 nm, while the upper limit thereof is preferably 2,000 nm. The hole transport layer with a thickness of 1 nm or more can sufficiently block electrons. The hole transport layer with a thickness of 2,000 nm or less is less likely to be a resistance to the hole transport, enhancing the photoelectric conversion efficiency. The lower limit of the thickness is more preferably 3 nm, while the upper limit thereof is more preferably 1,000 nm. The lower limit is still more preferably 5 nm, while the upper limit is still more preferably 500 nm.

The hole transport layer may be produced by, for example, a method including a hole transport layer forming step in which a hole transport layer is formed on the photoelectric conversion layer.

The hole transport layer may be formed on the photoelectric conversion layer by any method. Examples of the method include a method of applying a solution prepared by dissolving a hole transport material in an organic solvent and evaporating off the organic solvent and a method of forming a film in vacuo such as deposition or sputtering.

Examples of the material of the transparent electrode include, but are not particularly limited to, conductive transparent materials such as CuI, indium tin oxide (ITO), SnO₂, aluminum zinc oxide (AZO), indium zinc oxide (IZO), and gallium zinc oxide (GZO) and conductive transparent polymers. These materials may be used alone or in combination of two or more thereof.

The transparent electrode may be formed by, for example, a method including a transparent electrode forming step in which a transparent electrode is formed on the hole transport layer.

The transparent electrode may be formed on the hole transport layer by any method. Examples of the method include a method of performing sputtering using the above material, a method of performing electron beam evaporation using the above material, and a method of applying nano particles or nanotube of the above material.

In the flexible solar cell of the present invention, the laminate having a structure including the metal foil, electron transport layer, photoelectric conversion layer, hole transport layer, and transparent electrode stacked in the stated order is preferably further covered with a sealing layer. Covering with a sealing layer protects the laminate including the photoelectric conversion layer from the external environment, leading to sufficient durability. This allows production of a flexible solar cell with higher photoelectric conversion efficiency and better durability.

The material of the sealing layer is not particularly limited, and a known material may be used, regardless of whether it is organic or inorganic. Namely, the sealing layer may include an organic sealing layer made of an organic material or an inorganic sealing layer made of an inorganic material. Moreover, the sealing layer also preferably includes both an organic sealing layer and an inorganic sealing layer.

Examples of the organic material include curable resins and hot-melt resins. Examples of the inorganic meterial include inorganic oxides, inorganic nitrides, and inorganic sulfides, and may further include organic group-containing silicone resins. Specific examples include silicon oxide, tin oxide, zirconium oxide, magnesium oxide, complex oxides formed of two or more metals, aluminum nitride, and silicon nitride. The sealing layer preferably includes an inorganic sealing layer made of an inorganic oxide or an inorganic nitride from the viewpoint that its excellent gas-barrier properties contributes to further enhancement of the durability of the flexible solar cell.

The sealing layer may be produced by, for example, a method including a sealing step in which the laminate having a structure including the metal foil, electron transport layer, photoelectric conversion layer, hole transport layer, and transparent electrode stacked in the stated order is covered with a sealing layer.

Examples of the method for forming the sealing layer include, but are not particularly limited to, printing methods such as dispensing and screen printing in the case where the material used for the sealing layer is an organic material. In the case where the material used for the sealing layer is an inorganic material, examples of the method include sputtering and deposition.

The method for forming the sealing layer specifically include, for example, forming the sealing layer on the second electrode of the laminate so as to entirely cover the laminate. In a case where the first electrode is first formed in the laminate, the sealing layer is formed on the second electrode. The first electrode may be either a cathode (i.e., a metal foil or an electrode formed on a surface of the metal foil on the photoelectric conversion layer side with an insulating layer interposed therebetween) or an anode (i.e., a transparent electrode). The second electrode may be either an anode or a cathode.

The lower limit of the thickness of the organic sealing layer is preferably 100 nm, while the upper limit thereof is preferably 100,000 nm. The organic sealing layer with a thickness of 100 nm or more can sufficiently and completely cover the laminate. The organic sealing layer with a thickness of 100,000 nm or less can sufficiently block water vapor from the side face. The lower limit of the thickness is more preferably 500 nm, while the upper limit thereof is more preferably 50,000 nm. The lower limit is still more preferably 1,000 nm, while the upper limit is still more preferably 20,000 nm.

The lower limit of the thickness of the inorganic sealing layer is preferably 30 nm, while the upper limit thereof is preferably 3,000 nm. The inorganic sealing layer with a thickness of 30 nm or more can have a sufficient water vapor barrier property, improving the durability of the flexible solar cell. The inorganic sealing layer with a thickness of 3,000 nm or less generates only small stress even when the thickness thereof is increased. This suppresses peeling of the inorganic sealing layer, electrode, semiconductor layer, or the like. The lower limit of the thickness is more preferably 50 nm, while the upper limit thereof is more preferably 1,000 nm. The lower limit is still more preferably 100 nm, while the upper limit is still more preferably 500 nm.

The thickness of the inorganic sealing layer can be measured using an optical film thickness measurement system (e.g., FE-3000 available from Otsuka Electronics Co., Ltd.).

Fig. 2 schematically illustrates an exemplary flexible solar cell of the present invention. A flexible solar cell 1 illustrated in Fig. 2 includes a metal foil 2, an electron transport layer 3, a photoelectric conversion layer 4 containing an organic-inorganic perovskite compound, a hole transport layer 5, and a transparent electrode 6 formed in the stated order.

The flexible solar cell of the present invention is preferably produced by a method for producing a flexible solar cell containing an organic-inorganic perovskite compound represented by the formula R-M-X₃ (R represents an organic molecule, M represents a metal atom, X represents a halogen atom or a chalcogen atom), including: an electron transport layer forming step in which an electron transport layer is formed on a metal foil; a photoelectric conversion layer forming step in which a photoelectric conversion layer containing the organic-inorganic perovskite compound is formed on the electron transport layer and then annealed at a temperature of 80°C or higher; a hole transport layer forming step in which a hole transport layer is formed on the photoelectric conversion layer; and a transparent electrode forming step in which a transparent electrode is formed on the hole transport layer.

### - Advantageous Effects of Invention

The present invention can provide a flexible solar cell including a photoelectric conversion layer that contains an organic-inorganic perovskite compound and being excellent in light resistance and photoelectric conversion efficiency.

### BRIEF DESCRIPTION OF DRAWINGS

Fig. 1 is a schematic view illustrating an exemplary crystal structure of an organic-inorganic perovskite compound.
Fig. 2 is a cross-sectional view schematically illustrating an exemplary flexible solar cell of the present invention.

### DESCRIPTION OF EMBODIMENTS

Embodiments of the present invention are more specifically described in the following with reference to, but not limited to, examples.

### (Example 1)

To a 50 µm-thick metal foil made of aluminum was applied a titanium oxide paste containing polyisobutyl methacrylate as an organic binder and titanium oxide (mixture of particles having average particle sizes of 10 nm and 30 nm) by spin coating, and then dried at 150°C for ten minutes. Then, the dried substance was irradiated with ultraviolet light at an irradiation intensity of 500 mW/cm² for 15 minutes using a high pressure mercury lamp (HLR100T-2, available from Sen Lights Co., Ltd.), thereby forming a 200 nm-thick porous electron transport layer made of titanium oxide.

Next, a 1 M solution of lead iodide (metal halide compound) dissolved in N,N-dimethylformamide (DMF) was prepared, and applied to the porous electron transport layer to form a film by spin coating. Further, a 1% by weight solution of methyl ammonium iodide as an amine compound dissolved in 2-propanol was prepared. In the solution was immersed a sample obtained above by forming a film of lead iodide, thereby forming a layer containing CH₃NH₃PbI₃ that is an organic-inorganic perovskite compound. The resulting sample was subjected to annealing treatment at 120°C for 30 minutes.

To the organic-inorganic perovskite compound part of the annealed photoelectric conversion layer was applied a 1% by weight solution of poly(4-butylphenyl-diphenylamine)(available from 1-Material) in chlorobenzene by spin coating, thereby forming a hole transport layer having a thickness of 50 nm. Then, on the hole transport layer was formed a 300 nm-thick transparent electrode made of ITO by electron beam evaporation. Thus, a flexible solar cell was produced.

### (Examples 2 to 7)

A flexible solar cell was obtained in the same manner as in Example 1, except that the type of a metal foil used and the temperature of the annealing were changed as shown in Table 1.

### (Example 8)

A flexible solar cell was produced in the same manner as in Example 1, except that a 1% by weight solution of P3HT (available from Aldrich) in chlorobenzene was applied to the organic-inorganic perovskite compound part of the annealed photoelectric conversion layer by spin coating to form a hole transport layer having a thickness of 50 nm.

### (Example 9)

A flexible solar cell was produced in the same manner as in Example 1, except that on a 50 µm-thick metal foil made of aluminum were formed a film of zirconia (ZrO₂) as an insulating layer and a film of titanium (Ti) as an electrode each with a thickness of 500 nm in the stated order.

### (Example 10)

A flexible solar cell was produced in the same manner as in Example 9, except that aluminum (Al) was used as an electrode instead of titanium (Ti).

### (Example 11)

A flexible solar cell was produced in the same manner as in Example 9, except that a metal foil made of SUS was used instead of the metal foil made of aluminum and that polyimide (UPIA-VS, available from Ube Industries, Ltd.), instead of zirconia (ZrO₂), was formed into a 10 µm-thick film as an insulating layer by spin coating.

### (Comparative Example 1)

To a plastic substrate made of polyethylene naphthalate (PEN) was applied aluminum to form a film with a thickness of 100 nm by vacuum evaporation. A titanium oxide paste containing polyisobutyl methacrylate as an organic binder and titanium oxide (mixture of particles having average particle sizes of 10 nm and 30 nm) was applied thereto by spin coating, and then dried at 150°C for ten minutes. Then, the dried substance was irradiated with ultraviolet light at an irradiation intensity of 500 mW/cm² for 15 minutes using a high pressure mercury lamp (HLR100T-2, available from Sen Lights Co., Ltd.), thereby forming a 200 nm-thick porous electron transport layer made of titanium oxide.

Next, a 1 M solution of lead iodide (metal halide compound) dissolved in N,N-dimethylformamide (DMF) was prepared, and applied to the porous electron transport layer by spin coating to form a film. Further, a 1% by weight solution of methyl ammonium iodide as an amine compound dissolved in 2-propanol was prepared. In the solution was immersed a sample obtained above by forming a film of lead iodide, thereby forming a layer containing CH₃NH₃PbI₃ that is an organic-inorganic perovskite compound. The resulting sample was subjected to annealing treatment at 60°C for 30 minutes.

To the organic-inorganic perovskite compound part of the annealed photoelectric conversion layer was applied a 1% by weight solution of poly(4-butylphenyl-diphenylamine)(available from 1-Material) in chlorobenzene by spin coating, thereby forming a hole transport layer having a thickness of 50 nm. Then, on the hole transport layer was formed a 300 nm-thick transparent electrode made of ITO by electron beam evaporation. Thus, a flexible solar cell was produced.

### (Comparative Example 2)

A flexible solar cell was produced in the same manner as in Comparative Example 1, except that the temperature of the annealing was changed as shown in Table 1.

### (Comparative Example 3)

A flexible solar cell was produced in the same manner as in Comparative Example 2, except that on a plastic substrate made of polyethylene naphthalate (PEN) was formed a 300 nm-thick ITO film made of ITO by electron beam evaporation, ultrasonically washed with pure water, acetone, and methanol each for ten minutes in the stated order, and then dried, and that a gold film with a thickness of 100 nm was formed on the hole transport layer by vacuum evaporation.

### (Comparative Example 4)

A flexible solar cell was obtained in the same manner as in Comparative Example 2, except that a plastic substrate made of polyethylene terephthalate (PET), instead of polyethylene naphthalate (PEN), was used.

### <Evaluation>

The flexible solar cells obtained in the examples and comparative examples were evaluated as described below.

### (1) Evaluation of initial conversion efficiency

A power source (236 model, available from Keithley Instruments Inc.) was connected between the electrodes in a flexible solar cell, and the photoelectric conversion efficiency was measured using a solar simulator (available from Yamashita Denso Corp.) at an intensity of 100 mW/cm². The obtained photoelectric conversion efficiency was taken as the initial conversion efficiency. Evaluation was performed based on the following criteria.
○○ (Excellent): Initial conversion efficiency of 6% or more.
○ (Good): Initial conversion efficiency of 5% or more but less than 6%.
Δ (Acceptable): Initial conversion efficiency of 4% or more but less than 5%.
× (Poor): Initial conversion efficiency of less than 4%.

### (2) Evaluation of light resistance

The conversion efficiency after continuous irradiation with light for one hour using a solar simulator at an intensity of 100 mW/cm² was measured, and the retention rate relative to the initial conversion efficiency was calculated.
○ (Good): Retention rate of 70% or more.
Δ (Acceptable): Retention rate of 40% or more but less than 70%.
× (Poor): Retention rate of less than 40%.

### (3) Evaluation of variation in photoelectric conversion efficiency

Ten flexible solar cell samples were produced under the same condition, and the average of the photoelectric conversion efficiencies of these ten samples was calculated. Evaluation was performed based on the following criteria. ○○ (Excellent): Difference between the average and the minimum value of ten samples was less than 1%. ○ (Good): Difference between the average and the minimum value of ten samples was 1% or more but less than 2%. × (Poor): Difference between the average and the minimum value of ten samples was 2% or more.

**[Table 1]**

| | Structure of flexible solar cell | Annealing temperature (°C) | Evaluation | | |
|---|---|---|---|---|---|
| | | | Initial conversion efficiency | Light resistance | Variation in photoelectric conversion efficiency |
| Example 1 | Al foil/TiO₂/CH₃NH₃PbI₃/PolyTPD/ITO | 120 | ○○ | ○ | ○ |
| Example 2 | Al foil/TiO₂/CH₃NH₃PbI₃/PolyTPD/ITO | 100 | ○ | Δ | ○ |
| Example 3 | Al foil/TiO₂/CH₃NH₃PbI₃/PolyTPD/ITO | 150 | ○○ | ○ | ○ |
| Example 4 | Al foil/TiO₂/CH₃NH₃PbI₃/PolyTPD/ITO | 80 | ○ | Δ | ○ |
| Example 5 | Ti foil/TiO₂/CH₃NH₃PbI₃/PolyTPD/ITO | 120 | ○ | ○ | ○ |
| Example 6 | Cu foil/TiO₂/CH₃NH₃PbI₃/PolyTPD/ITO | 120 | ○ | ○ | ○ |
| Example 7 | SUS foil/TiO₂/CH₃NH₃PbI₃/PolyTPD/ITO | 120 | ○ | ○ | ○○ |
| Example 8 | Al foil/TiO₂/CH₃NH₃PbI₃/P3HT/ITO | 120 | Δ | ○ | ○ |
| Example 9 | Al foil/ZrO₂/Ti/TiO₂/CH₃NH₃PbI₃/PolyTPD/ITO | 120 | ○○ | ○ | ○ |
| Example 10 | Al foil/ZrO₂/Al/TiO₂/CH₃NH₃PbI₃/PolyTPD/ITO | 120 | ○○ | ○ | ○ |
| Example 11 | SUS foil/polyimide/Al/TiO₂/CH₃NH₃PbI₃/PolyTPD/ITO | 120 | ○ | ○ | ○○ |
| Comparative Example 1 | PEN/Al/TiO₂/CH₃NH₃PbI₃/PolyTPD/ITO | 60 | × | - | - |
| Comparative Example 2 | PEN/Al/TiO₂/CH₃NH₃PbI₃/PolyTPD/ITO | 150 | × | - | - |
| Comparative Example 3 | PEN/ITO/TiO₂/CH₃NH₃PbI₃/PolyTPD/Au | 150 | × | - | - |
| Comparative Example 4 | PET/Al/TiO₂/CH₃NH₃PbI₃/PolyTPD/ITO | 150 | × | - | - |

### INDUSTRIAL APPLICABILITY

The present invention can provide a flexible solar cell including a photoelectric conversion layer that contains an organic-inorganic perovskite compound and being excellent in light resistance and photoelectric conversion efficiency.

### REFERENCE SIGNS LIST

1: Flexible solar cell
2: Metal foil
3: Electron transport layer
4: Photoelectric conversion layer containing an organic-inorganic perovskite compound
5: Hole transport layer
6: Transparent electrode

## Claims

1. A flexible solar cell having a structure comprising:
a metal foil;
an electron transport layer;
a photoelectric conversion layer;
a hole transport layer; and
a transparent electrode stacked in the stated order,
the photoelectric conversion layer containing an organic-inorganic perovskite compound represented by the formula: R-M-X₃ where R represents an organic molecule, M represents a metal atom, and X represents a halogen atom or a chalcogen atom.

2. The flexible solar cell according to claim 1,
wherein the metal foil is constituted by a metal containing stainless steel.

3. The flexible solar cell according to claim 1,
wherein the metal foil is constituted by a metal containing aluminum.

4. The flexible solar cell according to claim 1, 2, or 3, having an electrode on a surface of the metal foil on the photoelectric conversion layer side with an insulating layer interposed therebetween.

5. The flexible solar cell according to claim 1, 2, 3, or 4,
wherein the hole transport layer contains an amorphous organic semiconductor.
